# DEMANDE DE BREVET EUROPEEN

(11) **EP 2 892 012 A1**
(43) Date de publication de la demande: **08.07.2015**
(21) Numéro de dépôt: 14305010.2
(22) Date de dépôt: 06.01.2014
(51) Int. Cl.: G06K 19/077

(54) **Module électronique, son procédé de fabrication, et dispositif électronique comprenant un tel module**

(71) Demandeur: Gemalto SA, 92190 Meudon (FR)
(72) Inventeur: Le Loc'h, Alain, 13705 LA CIOTAT (FR); Bertolotti, Jean-Marie, 13705 LA CIOTAT (FR); Fidalgo, Jean-Christophe, 13705 LA CIOTAT (FR)

(57) **Abrégé**

L'invention porte sur un module électronique de type double face destiné à équiper des dispositifs électroniques mixtes ou interconnectés. Le module (10) comprend un composant semi-conducteur (15) reporté sur une première face d'un film support diélectrique (11) et connectant ou destiné à être connecté électriquement à un circuit électrique. Le module est caractérisé en ce qu'il comprend, sur ladite première face du film support diélectrique (11), des pistes conductrices (20) imprimées présentant chacune au moins une première extrémité (21) électriquement reliée à un plot de contact dudit composant semi-conducteur (15) par l'intermédiaire d'un fil conducteur électrique (24).

## Description

### [Domaine de l'invention]

L'invention concerne le domaine technique des modules électroniques comprenant au moins un composant électronique, par exemple de type puce de circuit intégré, et destinés de préférence à connecter électriquement ce composant électronique à un circuit électrique. L'invention se rapporte également à un procédé de fabrication d'un tel module. Elle se rapporte enfin à des dispositifs électroniques comprenant un tel module électronique. De tels dispositifs peuvent se présenter par exemple sous forme de carte, d'étiquette, de ticket ou de livret et trouvent des applications notamment, mais non exclusivement, dans le contrôle d'accès, les transports, l'identification ou le paiement par exemple. Au sens large, un module peut être également un circuit imprimé.

### [Art Antérieur]

Il existe aujourd'hui différents types de dispositifs électroniques. Il existe notamment des dispositifs fonctionnant à contact, des dispositifs fonctionnant sans contact, des dispositifs dits « mixtes » fonctionnant avec et/ou sans contact, et des dispositifs dits « interconnectés » comprenant un ou plusieurs autres circuits électriques ou électroniques, connectés électriquement au module électronique et plus particulièrement au composant semi-conducteur qu'il renferme. De tels circuits électriques peuvent par exemple comprendre une antenne radio fréquence ou une antenne ultra haute fréquence et /ou un ou plusieurs composants électriques ou électroniques.

Dans ce qui suit, on se placera dans l'application préférée d'un dispositif électronique mixte ou d'un dispositif interconnecté, comprenant un module électronique, disposé dans une cavité ménagée dans le corps du dispositif, et destiné à être connecté électriquement à (ou connectant) au moins un autre circuit électrique. Ce dernier circuit électrique peut comprendre ou non, un ou plusieurs autres composants électriques/électroniques.

En général, pour ce type de dispositif, on utilise des modules électroniques dits « double face », qui comprennent une couche de cuivre assemblée sur chaque face d'un film support diélectrique. Un tel module double face est donc formé par assemblage d'un film diélectrique et de deux couches métallisées. La première couche métallisée est gravée pour délimiter les contours des plages de contact d'un bornier de connexion destiné à affleurer la surface du dispositif électronique dans lequel le module est inséré. La deuxième couche métallisée est gravée pour délimiter les contours de pistes conductrices. On peut en outre faire subir à ces deux couches métallisées un traitement de surface consistant à rajouter une couche de métallisation additionnelle, à base de Nickel et d'Or, formant une couche de passivation et les protégeant ainsi de l'oxydation. Sur la face du film diélectrique supportant la deuxième couche métallisée gravée sous forme de pistes conductrices, est fixé un composant semi-conducteur tel qu'une puce de circuit intégré par exemple. Classiquement, la puce est fixée sur le film diélectrique, sa face active tournée vers l'extérieur du film, et ses plots de contact sont connectés aux plages de contact du bornier de connexion par une technique bien connue sous la dénomination anglo-saxonne « wire bonding », consistant à utiliser des fils métalliques en or, aluminium, cuivre ou argent et à les faire passer à travers des réservations pratiquées dans l'épaisseur du film diélectrique, au regard des plages de contact à connecter. Les plots de contact de la puce sont en outre connectés aux pistes conductrices de la deuxième couche métallisée. La puce et les fils de connexion sont ensuite enrobés dans une résine de protection.

Cependant, un tel module double face nécessitant l'utilisation de deux couches métallisées revient cher. Le marché des dispositifs électroniques mixtes ou des dispositifs interconnectés est en pleine expansion et des modules électroniques de type double face doivent être produits en masse. Un tel module, de type double face, doit donc présenter une grande fiabilité et un prix de revient le plus bas possible.

Une solution alternative a été envisagée dans le passé pour réduire les coûts de revient d'un module double face. Cette solution, décrite dans la demande de brevet WO2000043951, consiste à réaliser une seule couche métallisée et à utiliser les plages de contact pour établir des connexions électriques entre les entrée/sorties du composant semi-conducteur et les bornes d'interconnexion d'une antenne. Cependant, cette solution n'est pas adaptable aux différentes configurations de puces de circuit intégré existantes, si bien qu'il faut prévoir autant de conceptions de modules électroniques qu'il y a de puces différentes. Par conséquent, cette solution est encore trop coûteuse pour une production industrielle à grande échelle.

### [Problème technique]

L'invention a donc pour but de remédier à au moins un des inconvénients de l'art antérieur. En particulier, l'invention vise à proposer une solution simple et peu coûteuse pour réaliser un module électronique de type double face, apte à permettre une connexion électrique entre le composant électronique qu'il renferme et un autre circuit électrique ou électronique, le module étant en outre adaptable à n'importe quelle configuration de composant électronique.

### [Résumé de l'invention]

Le principe de l'invention repose sur le fait qu'on réalise, sur la face du film diélectrique supportant le composant semi-conducteur, des pistes conductrices par impression d'encre métallique.

A cet effet, l'invention a pour objet un module électronique comprenant un composant semi-conducteur reporté sur une première face d'un film support diélectrique et destiné à être connecté électriquement à un circuit électrique, ledit module étant caractérisé en ce qu'il comprend, sur ladite première face du film support diélectrique, des pistes conductrices imprimées présentant chacune au moins une première extrémité électriquement reliée à un plot de contact dudit composant semi-conducteur par l'intermédiaire d'un fil conducteur électrique.

Ainsi, l'encre métallique n'est déposée qu'aux endroits nécessaires pour permettre l'établissement d'une connexion électrique et utilise une quantité de métal bien inférieure à une celle d'une couche métallisée que l'on grave ensuite. Le fait d'imprimer les pistes conductrices avec une encre métallique permet donc de réduire considérablement les coûts de revient du module. De plus, le fait d'imprimer les pistes conductrices permet d'adapter et de personnaliser le module à n'importe quelle configuration de composant électronique.

Selon d'autres caractéristiques optionnelles du module électronique :
- chaque piste conductrice imprimée comprend une deuxième extrémité formant une plage d'interconnexion destinée à être électriquement connectée à une borne d'interconnexion dudit circuit électrique,
- le film support diélectrique porte en outre, sur une deuxième face, une pluralité de plages de contact électriques, ledit composant semi-conducteur étant électriquement relié auxdites plages de contact électriques,
- une première extrémité du fil conducteur est fixée sur le plot de contact dudit composant semi-conducteur tandis que l'autre extrémité du fil conducteur passe à travers une réservation, pratiquée dans l'épaisseur du film diélectrique au regard d'un îlot de contact délimité dans une plage de contact, et est fixée sur ledit 'îlot de contact, et la première extrémité de la piste conductrice imprimée est réalisée dans ladite réservation, sur la surface dudit îlot de contact et débouche à la surface de la première face dudit film support diélectrique,
- le matériau de constitution des pistes conductrices imprimées est compatible avec le matériau de constitution du fil conducteur et réciproquement.
- le matériau de constitution des pistes conductrices imprimées est une encre conductrice comprenant des nanoparticules métalliques à base de l'un au moins des métaux suivants : or, argent, cuivre, aluminium, palladium, ou des mélanges à base de nanoparticules de cuivre enrobées d'étain, de nanoparticules de cuivre enrobées d'argent, de nanoparticules de cuivre enrobées de palladium, ou encore de nanoparticules de cuivre enrobées d'une couche de Ni/Au,
- le circuit électrique comprend une antenne radio fréquence, une antenne ultra haute fréquence, et/ou tout circuit électrique supportant au moins un autre composant semi-conducteur,
- le circuit électrique est une antenne réalisée sur la surface de la première face dudit film support diélectrique,
- avantageusement, cette antenne est également réalisée par impression d'encre conductrice,
- le circuit électrique est extérieur au module et noyé dans le corps d'un dispositif électronique dans lequel ledit module est destiné à être inséré,
- le circuit électrique peut comprendre une piste et/ou zone conductrice réalisée par impression d'encre (ou matière) conductrice sur le film support.

L'invention vise également à proposer un procédé de fabrication simplifié d'un module électronique destiné à être connecté électriquement à des bornes d'interconnexion d'un circuit électrique, ledit procédé comprenant une étape de report, sur une première face d'un film support diélectrique, d'un composant semi-conducteur, ledit procédé étant caractérisé en ce qu'il comprend en outre les étapes suivantes :
- imprimer des pistes conductrices sur ladite première face du film support diélectrique portant le composant semi-conducteur, chaque piste conductrice comprenant une première et une deuxième extrémité,
- relier électriquement au moins la première extrémité de chaque piste conductrice imprimée à un plot de contact du composant semi-conducteur, par l'intermédiaire d'un fil conducteur électrique,
- enrober le composant semi-conducteur et ses connexions dans une résine de protection.

Selon d'autres caractéristiques optionnelles du procédé de fabrication :
- le procédé comprend en outre une étape préalable consistant à assembler une couche métallisée sur une deuxième face du film support diélectrique, à réaliser une pluralité de plages de contact électriques dans ladite couche métallisée, et à connecter électriquement ledit composant semi-conducteur auxdites plages de contact électriques,
- la deuxième extrémité de chaque piste conductrice imprimée est réalisée sur une surface telle, qu'elle forme une plage d'interconnexion destinée à être électriquement connectée à une borne d'interconnexion dudit circuit électrique
- chaque extrémité du fil conducteur est fixée d'une part sur un plot de contact du composant semi-conducteur et d'autre part sur un îlot de contact électrique, dont les contours sont préalablement délimités dans une plage de contact, en passant à travers une réservation pratiquée dans l'épaisseur du film diélectrique au regard dudit îlot de contact, de sorte qu'il relie électriquement ledit plot de contact du composant semi-conducteur audit îlot de contact, et en ce que la première extrémité de la piste conductrice à relier est imprimée sur la surface dudit îlot de contact dans ladite réservation et débouche sur la face du film diélectrique supportant ledit composant semi-conducteur,
- l'impression des pistes conductrices est réalisée par l'une des techniques suivantes : jet d'encre, spray, LIFT, sérigraphie, flexographie ou encore héliographie.

L'invention se rapporte enfin à un dispositif électronique comprenant un circuit électrique noyé dans son corps, et un module électronique inséré dans une cavité ménagée dans son corps, ledit circuit électrique comprenant des bornes d'interconnexion à connecter audit module, caractérisé en ce que le module électronique est conforme au module décrit ci-dessus, ses plages d'interconnexion, formées par la deuxième extrémité des pistes conductrices imprimées sur le film diélectrique, sont disposées en regard des bornes d'interconnexion dudit circuit électrique et la connexion électrique entre lesdites plages d'interconnexion dudit module et lesdites bornes d'interconnexion dudit circuit électrique comprend un matériau conducteur électrique.

Ce dispositif constitue avantageusement un dispositif mixte à fonctionnement à contact et/ou sans contact, ou un dispositif interconnecté multi-composants. A titre d'exemple, ce peut être une carte à puce avec et/ou sans contact, un ticket avec et/ou sans contact, une étiquette avec et/ou sans contact, ou un livret de type passeport.

### [Brève description des figures]

D'autres particularités et avantages de l'invention apparaitront à la lecture de la description suivante faite à titre d'exemple illustratif et non limitatif, en référence aux Figures annexées qui représentent :
- La Figure 1, un schéma d'un module électronique selon l'invention vu par sa face supportant un composant semi-conducteur,
- La Figure 2, un schéma d'un module électronique vu par sa face supportant un composant semi-conducteur, selon une variante de réalisation,
- La Figure 3, un schéma d'un module électronique vu par sa face supportant un composant semi-conducteur, réalisé selon un autre mode de réalisation,
- La Figure 4, un schéma d'un module électronique vu par sa face supportant un composant semi-conducteur et une antenne radiofréquence,
- La Figure 5, un schéma en coupe d'un exemple de dispositif électronique comprenant un module selon l'invention, connecté à un circuit électrique noyé dans le corps dudit dispositif.

### [Description]

Les dispositifs électroniques peuvent se présenter sous différentes formes telles qu'une carte avec et/ou sans contact, une étiquette, un ticket, ou même un livret lorsqu'il s'agit d'un passeport d'identité par exemple. Ces dispositifs doivent satisfaire des normes telles que la norme ISO 7816 lorsqu'il s'agit d'un dispositif à contact ou la norme ISO14443 lorsque le dispositif renferme une interface de communication se présentant sous la forme d'une antenne par exemple.

L'invention s'applique à tout type de dispositif électronique comprenant un circuit électrique électriquement relié au composant semi-conducteur du module électronique. Dans les exemples décrits ci-après, le circuit électrique comprend une antenne radio fréquence, ou une antenne ultra haute fréquence. Cependant, le dispositif selon l'invention ne se limite pas à cet exemple et le circuit électrique peut avantageusement comprendre une telle antenne et/ou tout autre composant électronique.

Le principe de l'invention consiste à éviter l'utilisation de deux couches métalliques, trop couteuses, pour la réalisation d'un module de type double face destiné à équiper ces dispositifs.

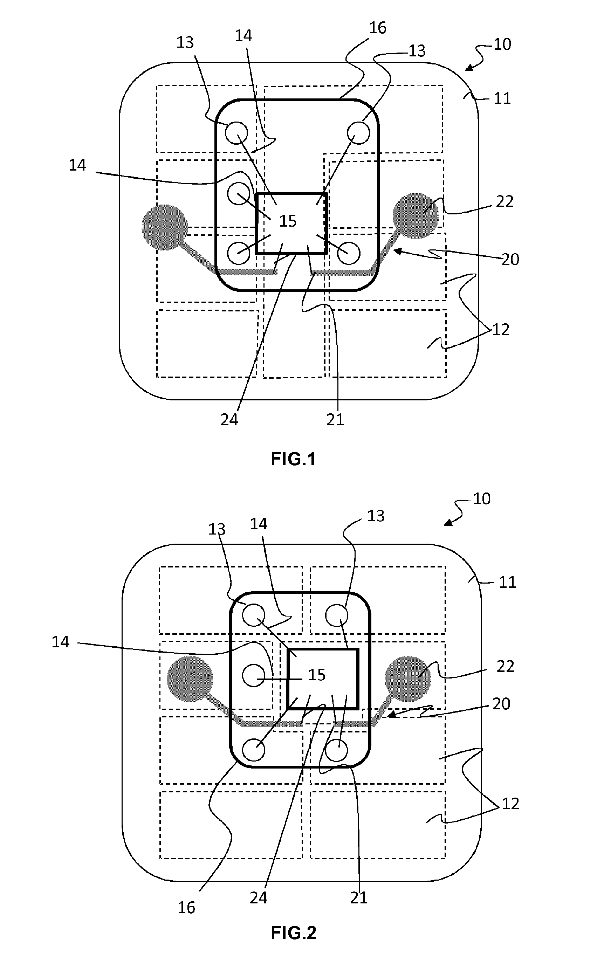

L'invention consiste donc à utiliser un module 10 standard, simple face, c'est-à-dire comprenant un film support diélectrique assemblé à une couche métallique sur une seule de ses faces. La Figure 1 illustre schématiquement un exemple d'un module électronique selon l'invention, vu de dessous, c'est-à-dire du côté de la face du film diélectrique 11 opposée aux plages de contact 12 électriques, représentées en traits pointillés sur la Figure 1. Les plages de contact 12 sont obtenues par gravure de la couche métallique assemblée au film diélectrique et forment un bornier de connexion destiné à affleurer la surface d'un dispositif électronique. De préférence, ces plages de contact subissent un traitement de surface consistant à rajouter une couche métallique additionnelle à base de nickel et d'or afin de former une couche de passivation. Le composant électronique 15, tel qu'une puce de circuit intégré par exemple, est alors reporté, par collage par exemple, sur la face du film diélectrique 11 opposée aux plages de contact 12. Des réservations 13, ou orifices, sont avantageusement pratiqués dans l'épaisseur du film diélectrique 11, au droit des plages de contact 12 à connecter au composant électronique 15. Les plots de contact du composant électronique 15 sont ensuite électriquement connectés aux plages de contact 12, par une technique classique dite de « wire bonding » en terminologie anglo-saxonne et consistant à utiliser des fils d'or, d'aluminium, d'argent ou de cuivre, et à les souder à chacune de leur extrémité respectivement à un plot de contact du composant semi-conducteur 15 et à une plage de contact 12 du bornier de connexion en faisant passer le fil dans une réservation 13 préalablement pratiquée dans l'épaisseur du film diélectrique 11.

Pour pouvoir créer un module de type double face à partir de ce module simple face, l'invention consiste ensuite à imprimer, sur la face du film diélectrique supportant le composant semi-conducteur 15, des pistes conductrices 20 permettant de relier électriquement le composant semi-conducteur 15 à un autre circuit électrique qui peut être extérieur au module, ou éventuellement sur la surface du film diélectrique 11 du module.

Dans ce cas, les pistes conductrices présentent deux extrémités. Une première extrémité 21 est destinée à être reliée électriquement à un plot de contact du composant semi-conducteur 15, tandis que l'autre extrémité 22 est imprimée sous la forme d'une plage d'interconnexion, présentant une surface supérieure à celle de la première extrémité. A titre d'exemple, la surface de cette plage d'interconnexion 22 pourra être de l'ordre de 1mm². Cette plage d'interconnexion est destinée à être électriquement connectée aux bornes d'interconnexion d'un circuit électrique, telles que par exemple les bornes d'extrémité d'une antenne radiofréquence.

Selon un premier mode de réalisation, et tel qu'illustré sur la Figure 1, la première extrémité de chaque piste conductrice est alors reliée électriquement à un plot de contact du composant semi-conducteur 15 par la technique classique de « wire bonding ». Pour cela, on fixe, par soudure par exemple, chaque extrémité d'un fil conducteur 24, tel qu'un fil d'or, d'aluminium, d'argent ou de cuivre par exemple, respectivement sur le plot de contact du composant semi-conducteur 15 et sur la première extrémité 21 d'une piste conductrice 20 imprimée. Le composant semi-conducteur et ses connexions électriques sont ensuite enrobées dans une résine de protection 16, à l'exception des plages d'interconnexion 22 définies par la deuxième extrémité des pistes conductrices imprimées et destinées à être électriquement connectées aux bornes d'interconnexion d'un circuit électrique.

Dans ce cas, la technique d'impression utilisée peut être une technique d'impression jet d'encre, spray ou LIFT (acronyme anglais pour « Laser Induced Forward Transfert ») qui est une technique de dépôt assisté par Laser, par sérigraphie, flexographie ou héliographie. De préférence, les pistes conductrices 20 sont imprimées par jet d'encre, spray ou LI FT.

Ces techniques d'impression utilisent une encre conductrice choisie parmi l'une au moins des encres suivantes : une encre à base de nanoparticules métalliques, comprenant par exemple de l'or, de l'argent, du cuivre, du Palladium, de l'aluminium, ou encore des mélanges à base de nanoparticules de cuivre enrobées d'étain, de nanoparticules de cuivre enrobées d'argent, de nanoparticules de cuivre enrobées de palladium, ou encore de nanoparticules de cuivre enrobées d'une couche de Ni/Au.

Ces encres présentent en outre une grande compatibilité avec les techniques de connexions utilisées dans les procédés de fabrication classiques de cartes, et notamment avec les techniques de connexion de type « wire bonding » ou à base de colle à argent. Une telle compatibilité permet l'obtention de connexions électriques de bonne qualité.

L'impression d'encre conductrice pour réaliser les pistes conductrice permet d'adapter le module en fonction de la configuration des plots de contact du composant semi-conducteur 15 à reporter sur le module. Par conséquent, la réalisation d'un tel module de type double face est très adaptable et peut être personnalisée en fonction du composant semi-conducteur 15 à reporter.

La réalisation des pistes conductrices 20 par impression d'encre conductrice n'utilise que peu de métal, surtout en impression par jet d'encre où l'épaisseur d'encre appliquée est faible et de l'ordre de quelques centaines de nm à quelques µm. De plus, on dépose l'encre métallique juste aux endroits nécessaires pour définir les pistes conductrices, si bien que la face du diélectrique supportant la puce ne comprend que très peu de métal, et présente de l'espace libre pouvant servir à y reporter d'autres composants et/ou circuit électrique. Le coût de revient d'un tel module est donc considérablement réduit par rapport à un module double face classique.

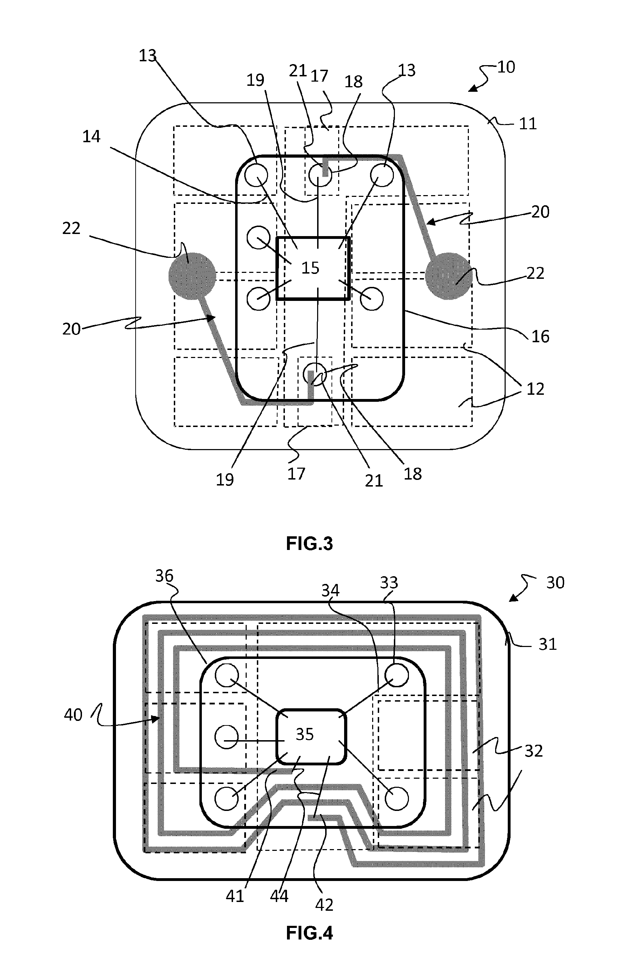

Lorsque l'épaisseur de l'encre est faible, notamment lorsque les pistes sont imprimées par la technique de jet d'encre qui implique un dépôt de faible épaisseur et n'utilisant que peu de matière, la connexion électrique avec un fil conducteur peut s'avérer délicate à réaliser. De plus, cette connexion risque de ne pas résister suffisamment aux contraintes de torsion ou de flexion, lors de la manipulation du dispositif électronique dans lequel le module est inséré. Dans ce cas, un deuxième mode de réalisation peut être envisagé afin de renforcer la robustesse de la liaison électrique entre un fil conducteur et une piste conductrice imprimée. Selon ce deuxième mode de réalisation, illustré sur la Figure 3, la connexion électrique entre une piste conductrice 20 imprimée et un plot de contact du composant semi-conducteur 15 est réalisée en utilisant un fil conducteur 19 et une portion de plage de contact en tant que point relai.

Selon ce deuxième mode de réalisation, on définit, pour chaque piste conductrice à connecter au composant semi-conducteur 15, un îlot 17 dans une plage de contact électrique 12 du bornier de connexion. Pour cela, on grave par exemple une portion de plage de contact, par exemple une portion de la plage réservée à la masse conformément à la norme ISO 7816. Le fait de graver une portion de plage de contact permet d'isoler un îlot de contact 17 et de s'en servir en tant que point relai dans une connexion électrique. L'ilot de contact 17 ainsi définit est alors relié électriquement par la technique classique de wire bonding à un plot du composant semi-conducteur 15, en passant un fil conducteur 19 dans une réservation 18 pratiquée dans l'épaisseur du film diélectrique 11 au droit de l'ilot de contact 17. L'extrémité 21 de la piste conductrice 20 imprimée devant être connectée à ce plot de contact est alors imprimée directement sur la surface de l'îlot de contact 17, dans la réservation 18 pratiquée au droit de l'ilot 17, et débouche sur la surface du diélectrique 11.

Pour pouvoir imprimer dans la réservation 18, dont les parois sont en général verticales, sans pour autant affecter la continuité électrique des pistes conductrices 20 qui débouchent sur la surface du film diélectrique 11, on préfère utiliser la technique d'impression par spray ou LIFT.

Un troisième mode de réalisation, illustré sur la Figure 2, consiste à reporter le composant semi-conducteur 15 sur le film diélectrique 11 de manière décentrée par rapport au bornier de connexion formé par les plages de contact 12 de la face opposée.

Un bornier de connexion de carte à puce conforme à la norme ISO 7816 comporte 6 ou 8 plages de contact 12 électriques utiles. Les plages de contact sont nommées C1 à C8 dans la norme ISO 7816-2. En outre la norme prévoit l'attribution des plages de contact à des signaux particulier: la plage C1 reçoit la tension d'alimentation Vcc, C2 supporte le signal RST d'initialisation, C3 correspond à un signal d'horloge CLK, C4 correspond au signal de données D+ pour une communication USB mais peut être utilisé pour autre chose que l'USB, C5 reçoit une tension de masse GND, C6 est destinée à recevoir une tension VPP de programmation de carte à mémoire mais n'est plus utilisée actuellement, C7 correspond à un signal I/O d'échange de données, et C8 correspond au signal de données D-pour une communication USB mais peut être utilisé pour autre chose que l'USB.

Le composant semi-conducteur 15 peut être reporté de manière décentrée par rapport au centre du bornier de connexion. Il peut par exemple être reporté en regard de la plage de contact normalisée C6 conformément à la norme ISO7816. Le fait de décentrer l'emplacement du composant semi-conducteur 15 par rapport au bornier de connexion, permet de gagner de la place à la surface du film diélectrique 11 en réduisant la zone d'enrobage 16 et en recentrant également les plages d'interconnexion 22 imprimées. De cette manière on libère de la place sur la face du film diélectrique 11 destinée à être fixée dans la cavité d'un corps de dispositif électronique. Cette place libérée permet par exemple d'augmenter la surface de collage du module dans la cavité d'un dispositif électronique et de renforcer ainsi la résistance du module à l'arrachement.

Dans une autre variante de réalisation, le gain de place engendré par l'impression des pistes conductrices 20 sur la face du film diélectrique 11, notamment lorsque la puce est reportée de manière décentrée, permet d'envisager la réalisation d'un circuit électrique directement sur le module électronique.

Dans un autre exemple, illustré sur la Figure 4, les pistes conductrices du module 30 peuvent d'ailleurs être confondues avec le circuit électrique, notamment lorsque celui-ci prend la forme d'une antenne radiofréquence 40 par exemple. Dans ce cas, l'antenne 40 est réalisée par impression d'encre conductrice à la surface du film diélectrique 31, autour du composant 35, et ses deux extrémités 41, 42 sont électriquement reliées à un plot de contact du composant semi-conducteur 35 au moyen d'un fil conducteur électrique 44. Le composant 35 et les fils de connexion sont ensuite enrobés dans la résine de protection 36. Dans le cas d'une antenne, il faudra toutefois veiller à isoler les spires destinées à être chevauchées, par un matériau isolant afin d'éviter l'apparition de court-circuit.

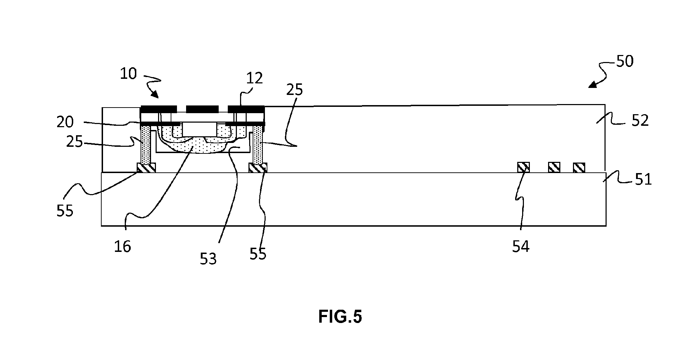

La Figure 5 schématise une vue en coupe d'un dispositif électronique 50 se présentant sous la forme d'une carte à puce mixte. Cette carte renferme une antenne 54, 55 radiofréquences. Le corps de carte comprend plusieurs couches, référencées 51 et 52 sur la Figure 5. Une cavité 53 ménagée dans le corps de carte est destinée à recevoir le module électronique 10 selon l'invention. Les bornes d'extrémité 55 de l'antenne se situent de part et d'autre de la cavité 53. Des puits 25 sont creusés dans le corps de carte, au droit des bornes d'extrémité 55 de manière à les découvrir. Puis, un matériau conducteur électrique, de type polymère conducteur par exemple, est utilisé pour remplir les puits 25 afin de connecter électriquement les bornes d'extrémité 55 de l'antenne noyée dans le corps de carte 51, 52, aux plages d'interconnexion 22 des pistes conductrices 20 imprimées sur la face cachée du module 10.

Le module de type double face qui vient d'être décrit présente l'avantage d'être très peu coûteux car il utilise très peu de métal sur sa deuxième face, opposée aux plages de contact. Il est de plus modulable car les pistes conductrices sont imprimées en fonction de la configuration du composant semi-conducteur à reporter. Par conséquent, le module utilisé est un module simple face, peu coûteux, qui est personnalisé par impression d'encre conductrice pour en faire un module de type double face, apte à relier électriquement son composant semi-conducteur à un circuit électrique disposé à l'extérieur du module ou sur une surface libre du film diélectrique du module.

Selon un autre aspect de l'invention (non représenté), notamment dans le cadre de module sous forme de circuits électroniques imprimés, le circuit électrique auquel est connecté le composant du module, peut comprendre une piste 20 et/ou zone conductrice 22. Ces dernières peuvent être portées par le film support et réalisées par impression d'encre (ou matière) conductrice.

## Revendications

1. Module électronique (10) comprenant un composant semi-conducteur (15) reporté sur une première face d'un film support diélectrique (11) et connectant ou destiné à être connecté électriquement à un circuit électrique, ledit module étant **caractérisé en ce qu'**il comprend, sur ladite première face du film support diélectrique (11), des pistes conductrices (20) imprimées présentant chacune au moins une première extrémité (21) électriquement reliée à un plot de contact dudit composant semi-conducteur (15) par l'intermédiaire d'un fil conducteur électrique (19 ; 24).

2. Module électronique selon la revendication 1, **caractérisé en ce que** chaque piste conductrice (20) imprimée comprend une deuxième extrémité (22) formant une plage d'interconnexion destinée à être électriquement connectée à une borne d'interconnexion dudit circuit électrique.

3. Module électronique selon l'une des revendications 1 à 2, **caractérisé en ce que** le film support diélectrique (11) porte en outre, sur une deuxième face, une pluralité de plages de contact (12) électriques, ledit composant semi-conducteur (15) étant électriquement relié auxdites plages de contact (12) électriques.

4. Module électronique selon les revendications 1 et 3, **caractérisé en ce qu'**une première extrémité du fil conducteur (19) est fixée sur le plot de contact dudit composant semi-conducteur (15) tandis que l'autre extrémité du fil conducteur (19) passe à travers une réservation (18), pratiquée dans l'épaisseur du film diélectrique (11) au regard d'un îlot de contact (17) délimité dans une plage de contact (12), et est fixée sur ledit îlot de contact (17), et **en ce que** la première extrémité (21) de la piste conductrice (20) imprimée est réalisée dans ladite réservation (18), sur la surface dudit îlot de contact (17) et débouche à la surface de la première face dudit film support diélectrique (11).

5. Module électronique selon l'une des revendications 1 à 4, **caractérisé en ce que** le matériau de constitution des pistes conductrices (20) imprimées est compatible avec le matériau de constitution du fil conducteur (19 ; 24) et réciproquement.

6. Module électronique selon l'une des revendications 1 à 5, **caractérisé en ce que** le matériau de constitution des pistes conductrices (20) imprimées est une encre conductrice comprenant des nanoparticules métalliques à base de l'un au moins des métaux suivants : or, argent, cuivre, aluminium, palladium, ou des mélanges à base de nanoparticules de cuivre enrobées d'étain, de nanoparticules de cuivre enrobées d'argent, de nanoparticules de cuivre enrobées de palladium, ou encore de nanoparticules de cuivre enrobées d'une couche de Ni/Au.

7. Module électronique selon l'une des revendications 1 à 6, **caractérisé en ce que** le circuit électrique comprend une antenne radio fréquence, une antenne ultra haute fréquence, et/ou tout circuit électrique supportant au moins un autre composant semi-conducteur.

8. Module électronique selon l'une des revendications 1 à 7, **caractérisé en ce que** le circuit électrique est une antenne réalisée sur la surface de la première face dudit film support diélectrique (11).

9. Module électronique selon l'une des revendications 3 à 8, **caractérisé en ce que** le composant semi-conducteur (15) est fixé sur ladite première face dudit film support diélectrique (11), de sorte qu'il soit décentré par rapport au centre du bornier de connexion formé par les plages de contact (12).

10. Procédé de fabrication d'un module électronique (10) destiné à être connecté électriquement à des bornes d'interconnexion d'un circuit électrique, ledit procédé comprenant une étape de report, sur une première face d'un film support diélectrique (11), d'un composant semi-conducteur (15), ledit procédé étant **caractérisé en ce qu'**il comprend en outre les étapes suivantes :
- imprimer des pistes conductrices (20) sur ladite première face du film support diélectrique (11) portant le composant semi-conducteur (15), chaque piste conductrice (20) comprenant une première (21) et une deuxième (22) extrémité,
- relier électriquement au moins la première extrémité (21) de chaque piste conductrice (20) imprimée à un plot de contact du composant semi-conducteur (15) par l'intermédiaire d'un fil conducteur électrique (19 ; 24),
- enrober le composant semi-conducteur et ses connexions dans une résine de protection (16).

11. Procédé selon la revendication 10, **caractérisé en ce qu'**il comprend en outre une étape préalable consistant à assembler une couche métallisée sur une deuxième face du film support diélectrique (11), à réaliser une pluralité de plages de contact (12) électriques dans ladite couche métallisée, et à connecter électriquement ledit composant semi-conducteur (15) auxdites plages de contact (12) électriques.

12. Procédé selon l'une des revendications 10 à 11, **caractérisé en ce que** la deuxième extrémité (22) de chaque piste conductrice (20) imprimée est réalisée sur une surface telle, qu'elle forme une plage d'interconnexion destinée à être électriquement connectée à une borne d'interconnexion dudit circuit électrique

13. Procédé selon l'une des revendications 11 à 12, **caractérisé en ce que** chaque extrémité du fil conducteur (19) est fixée d'une part sur un plot de contact du composant semi-conducteur (15) et d'autre part sur un îlot de contact (17) électrique, dont les contours sont préalablement délimités dans une plage de contact (12), en passant à travers une réservation (18) pratiquée dans l'épaisseur du film diélectrique (11) au regard dudit îlot de contact (17), de sorte qu'il relie électriquement ledit plot de contact du composant semi-conducteur (15) audit îlot de contact (17), et **en ce que** la première extrémité (21) de la piste conductrice (20) à relier est imprimée sur la surface dudit îlot de contact (17) dans ladite réservation (18) et débouche sur la face du film diélectrique (11) supportant ledit composant semi-conducteur (15).

14. Procédé selon l'une des revendications 10 à 13, **caractérisé en ce que** l'impression des pistes conductrices (20) est réalisée par l'une des techniques suivantes : jet d'encre, spray, LIFT, sérigraphie, flexographie ou encore héliographie.

15. Dispositif électronique (50) comprenant un circuit électrique (54) noyé dans son corps, et un module électronique (10) inséré dans une cavité (53) ménagée dans son corps, ledit circuit électrique comprenant des bornes d'interconnexion (55) à connecter audit module (10), **caractérisé en ce que** le module électronique (10) est conforme au module selon l'une au moins des revendications 1 à 9, ses plages d'interconnexion formées par la deuxième extrémité (22) des pistes conductrices (20) imprimées sur le film diélectrique (11) sont disposées en regard des bornes d'interconnexion (55) dudit circuit électrique et la connexion électrique (25) entre lesdites plages d'interconnexion (22) dudit module (10) et lesdites bornes d'interconnexion (55) dudit circuit électrique (54) comprend un matériau conducteur électrique.

16. Dispositif électronique selon la revendication 15, **caractérisé en ce qu'**il constitue un dispositif mixte à fonctionnement à contact et/ou sans contact, ou un dispositif interconnecté multi-composants.
